# EUROPEAN PATENT APPLICATION

(11) **EP 4 480 741 A1**
(43) Date of publication of application: **25.12.2024**
(21) Application number: 23180663.9
(22) Date of filing: 21.06.2023
(51) Int. Cl.: B60L 53/302, B60L 53/30

(54) **COOLING SYSTEM FOR EV CHARGING INFRASTRUCTURE**

(71) Applicant: ABB E-mobility B.V., 2629 JG Delft (NL)
(72) Inventor: VARMA PADAYAMBATH, Nikhil, 3023KJ Rotterdam (NL); ATAEI DADAVI, Iman, 2597CA The Hague (NL); MARTINEZ BUENO, Patricia, 2523JB Den Haag (NL); KORTE, Walter, 2718CT Zoetermeer (NL); PRABHAKARAN, Vignesh, 2521AA Den Haag (NL)
(74) Representative: Maiwald GmbH

(57) **Abstract**

There is provided a cooling system (100) for electric vehicle charging infrastructure (EVCI). The cooling system exhibits a centralized cooling arrangement in which heat is collected from a plurality of heat-generating components of the EVCI and dissipated into the surrounding environment via a common outlet. The cooling system comprises: a thermal energy storage element (102) configured to act as a buffer for temporarily storing the heat collected from the plurality of heat-generating components; and a primary heat exchanger (110), serving as the common outlet, wherein the primary heat exchanger is configured to dissipate the heat temporarily stored by the thermal energy storage element with the surrounding environment.

## Description

### FIELD OF THE INVENTION

The invention relates to cooling systems and methods for electric vehicle charging infrastructure.

### BACKGROUND

Electric vehicle (EV) charging installations currently comprise multiple charging posts each equipped with liquid cooled cables have a cooling unit that help remove excess heat from the cables. In addition, the power cabinets or power modules supplying energy to the charging posts may also require adequate cooling. Such EV charging installations may suffer from noise, complexity, and an inability to provide the requisite cooling capacity during peak hours.

### SUMMARY

To better address one or more of these concerns, in a first aspect of invention there is provided a cooling system for electric vehicle charging infrastructure (EVCI). The cooling system exhibits a centralized cooling arrangement in which heat is collected from a plurality of heat-generating components of the EVCI and dissipated into the surrounding environment via a common outlet. The cooling system comprises a thermal energy storage element configured to act as a buffer for temporarily storing the heat collected from the plurality of heat-generating components. The cooling system further comprises a primary heat exchanger, serving as the common outlet, wherein the primary heat exchanger is configured to dissipate the heat temporarily stored by the thermal energy storage element to the surrounding or ambient environment. The heat-generating components of the EVCI may comprise one or more electric vehicle (EV) chargers, power modules, power cabinets, or the like. In other examples, the heat-generating components may comprise components outside of the EVCI itself, such as one or more electric vehicles or parts thereof such as batteries. The heat-generating components may alternatively be describable as heat-sensitive or temperature-sensitive components.

By acting as a buffer, the thermal energy storage element may thus allow the cooling system to provide additional cooling capacity during surges in demand, for example at peak hours, compared to cooling systems which do not include such a thermal buffer.

By virtue of the centralized cooling arrangement, the primary heat exchanger is able to serve as the common outlet for all the heat collected from the heat-generating components into the environment. Heat captured from multiple heat-generating components may therefore be dissipated into the environment by way of a single, common heat exchanger which, by virtue of its size, may function more efficiently and more quietly than an equivalent collection of smaller heat exchangers having the same cooling capacity. It will be appreciated however that the cooling system may comprise multiple such primary heat exchangers, each serving a plurality of heat-generating components, while nonetheless providing the stated benefits in contrast with a decentralized arrangement in which each charging point independently dissipates heat directly to the surrounding environment.

The cooling system may further comprise a primary pump and a primary conduit, wherein the thermal energy storage element, the primary pump, and the primary conduit form a primary loop for circulating a primary coolant for the transfer of heat collected from the heat-generating components to the thermal energy storage element. Moreover, the cooling system may further comprise at least one secondary loop for circulating a secondary coolant (which may be the same or a different fluid as the primary coolant) for the transfer of heat from a respective one or more of the heat-generating components to the primary loop. The secondary loop may be positioned at a respective charging station, the charging station comprising a secondary coolant container (e.g., a tank), a secondary pump, and a secondary conduit, wherein the secondary coolant container, the secondary pump, and the secondary conduit together form the secondary loop. In this way, the thermal enery storage element may also form part of the primary loop which is configured to transfer heat from the heat-generating components to the thermal energy storage element and subsequently, via the primary heat exchanger, to the surrounding environment, while one or more of the charging stations may comprise a secondary loop for independently transferring heat from the respective one or more heat-generating components to the primary loop.

The charging station may further comprise a secondary heat exchanger for exchanging heat collected by the secondary loop from the respective one or more heat-generating components with the primary loop. The coolant to be circulated in the primary loop may comprise a liquid coolant. Similarly, the coolant to be circulated in the secondary loop may comprise a liquid coolant. In such cases, the secondary heat exchanger may comprise a liquid-liquid heat exchanger, which obviates the need for less efficient and noisier liquid-to-air heat exchangers at each charging station, which would be necessary if each charging point were to dissipate heat captured from the heat-generating components directly into the surrounding air. Such an arrangement furthermore reduces system complexity. Such liquid-liquid heat exchangers are typically more efficient, smaller, and quieter than their liquid-to-air counterparts. In the case that the thermal reservoir itself may be a phase change material, a heat exchanging element may be present in the thermal reservoir that transfers heat from the primary coolant to the phase change material. Thus, even in this case, the secondary heat exchanger may comprise a liquid-liquid heat exchanger.

The primary heat exchanger may be positioned remotely from one or more charging stations at which the electric vehicles are to be charged. The primary heat exchanger in a centralized arrangement allows for such positional flexibility since it need not be located in close proximity to the charging stations. Positioning the primary heat exchanger remotely from the charging stations may provide further benefits in terms of reduced noise and footprint at the charging stations, and thereby improved user acceptance.

According to a second aspect of the invention, there is provided electric vehicle charging infrastructure comprising the cooling system of the first aspect.

According to a third aspect, there is provided a method of controlling the cooling system of the first aspect. The method comprises: controlling the primary heat exchanger to dissipate the heat temporarily stored by the thermal energy storage element with the surrounding environment. Controlling the primary heat exchanger may comprise controlling the primary heat exchanger to operate intermittently while at least one of the heat-generating components is operating. Controlling the primary heat exchanger to operate intermittently may comprise controlling the primary heat exchanger to refrain from operating during at least a portion of the time that the at least oneof the heat-generating components is operating . Controlling the primary heat exchanger may comprise operating the primary heat exchanger depending on a cooling demand or on a thermal state of the system (e.g., the primary tank temperature), independently of whether any of the heat-generating components is currently operating. Controlling the primary heat exchanger may comprise operating the primary heat exchanger while no vehicles are being actively charged, for example to cool down the thermal energy storage element. In this way, the question of whether the primary heat exchanger is operating is not entirely dependent on the question of whether any electric vehicles are currently being charged.

Advantegeously, due to increased thermal capacity of the centralized cooling arrangement when it includes the thermal energy storage element, the primary heat exchanger need not be continuously operated, or may be operated less frequently or for shorter periods of time, since the temperature rise in the stored coolant will be lower than would otherwise be the case in a system without thermal energy storage. For example, the primary heat exchanger may be operated primarily at nighttime or during off-peak hours, to reduce noise impact on users as well as energy costs, while also operating more efficiently because ambient temperature is typically lower at night.

The method of the third aspect may be computer implemented.

According to a fourth aspect, there is provided a computing system configured to perform the method of the third aspect.

According to a fifth aspect, there is provided a computer program (product) comprising instructions which, when executed by a computing system, enable or cause the computing system to perform the method of the third aspect.

According to a sixth aspect, there is provided a computer-readable (storage) medium comprising instructions which, when executed by a computing system, enable or cause the computing system to perform the method of the third aspect. The computer-readable medium may be transitory or non-transitory, volatile or non-volatile.

The invention may include one or more aspects, examples or features in isolation or combination whether specifically disclosed in that combination or in isolation. Any optional feature or sub-aspect of one of the above aspects applies as appropriate to any of the other aspects.

These and other aspects of the invention will be apparent from and elucidated with reference to the embodiments described hereinafter.

The "thermal energy storage element" may comprise "sensible heat storage" in case of a liquid coolant and/or "latent heat storage" in case of a phase change material. In the case of a liquid coolant, the thermal energy storage element may further comprise a tank, vessel, reservoir, or other receptacle for the liquid. In the case of a phase-change material, the thermal energy storage element may comprise a container of appropriate kind for the phase-change material. An alternative approach is to use thermochemical storage.

The term "buffer" as used herein may be understood in the sense that it provides for a storage of heat energy (i.e., thermal inertia or thermal capacitance) which is larger than that which would otherwise be possible, for example by providing a repository of coolant such that the total volume of coolant is larger than that which is merely present or circulating in the primary loop. In other words, it provides capacity for storing an amount of coolant that is greater than that which can be contained only by the primary conduit, the primary pump, and any other components which form part of the primary loop. In case of thermal energy storage devices other than sensible energy storage (a tank of coolant), the buffer may provide an inventory of latent heat or chemical energy that allows absorption and storage of an amount of heat which is larger than that which would otherwise be possible. The large thermal capacitance of this buffer (thermal energy storage element) allows accumulation of heat from multiple charge stations or power cabinets with a modest rise in temperature (or phase change).

The term "charging station" as used herein may be taken to apply to any charging post, charging cabinet, power cabinet, power module, and so on, regardless of its form factor or size. Heat in these charge stations is generated at the (liquid cooled) charge cable which connects to the EV or at the internal power modules or other components associated with the charging station.

The expression "positioned remotely" may be taken to mean that the element in question, e.g. the primary heat exchanger, may be positioned farther from the electric vehicles than would otherwise be the case, for example that it is located farther from a given charging station than the secondary heat exchanger of that charging station.

The term "loop" used in connection with the circulation of coolant may be replaced by "circuit", as appropriate.

The term "unit" as used herein may be used interchangeably with equivalent terms such as "circuitry" or "engine". Any such term may refer to hardware, firmware, and/or software configured to perform any of the operations described herein. Hardware may comprise hardwired circuitry such as state machine circuitry and/or programmable circuitry such as computer processors comprising one or more individual instruction processing cores. Software may be embodied as a software package, code, instructions, instruction sets and/or data recorded on at least one transitory or non-transitory computer readable storage medium. Firmware may be embodied as code, instructions or instruction sets and/or data hard-coded in memory devices (e.g., non-volatile memory devices).

The indefinite article "a" or "an" does not exclude a plurality. In addition, the articles "a" and "an" as used herein should generally be construed to mean "one or more" unless specified otherwise or clear from the context to be directed to a singular form.

Unless specified otherwise, or clear from the context, the phrases "one or more of A, B and C", "at least one of A, B, and C", and "A, B and/or C" as used herein are intended to mean all possible permutations of one or more of the listed items. That is, the phrase "A and/or B" means (A), (B), or (A and B), while the phrase "A, B, and/or C" means (A), (B), (C), (A and B), (A and C), (B and C), or (A, B, and C).

The term "comprising" does not exclude other elements or steps. Furthermore, the terms "comprising", "including", "having" and the like may be used interchangeably herein.

### BRIEF DESCRIPTION OF THE DRAWINGS

A detailed description will now be given, by way of example only, with reference to the accompanying drawings, in which:-
FIG. 1 illustrates a cooling system for EV charging infrastructure;
FIG. 2 illustrates an individual charging station of the cooling system of FIG. 1;
FIG. 3 illustrates a control system of the cooling system of FIG. 1;
FIG. 4 illustrates signals utilized by the control system of FIG. 3;
FIG. 5 is a flowchart illustrating a control algorithm executed by the master control unit of FIG. 3;
FIG. 6 is a flowchart illustrating a control algorithm executed by the slave control unit of FIG. 3; and
FIG. 7 illustrates a computing system that can be used in accordance with the systems and methods disclosed herein.

### DETAILED DESCRIPTION

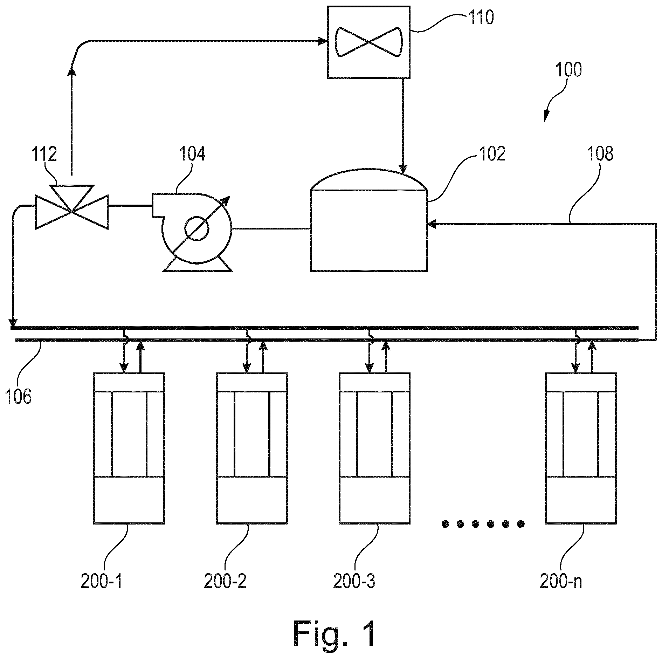

FIG. 1 shows a cooling system 100 for EV charging infrastructure. The cooling system comprises both a primary side and a secondary side. On the primary side, the cooling system 100 comprises a thermal energy storage element, which in this non-limiting example is a primary tank 102 for storing coolant, along with a primary pump 104, and a primary conduit 106. The primary pump 104 is configured to circulate the coolant through a circuit comprising the primary tank 102, the primary pump 104, and the primary conduit 106. The primary tank 102, the primary pump 104, and the primary conduit 106 taken together thus form a primary loop 108. The primary tank 102 is provided with a primary heat exchanger 110 configured to dissipate heat from the primary tank 102 to the surrounding environment. At least one primary flow control valve 112 is provided for regulating the operation of the primary heat exchanger 110. The valve 112 is used to control the flow through the primary heat exchanger 110. For example, the valve 112 may allow a certain portion of flow to go through the charging stations 200 while allowing some percentage to flow through the primary heat exchanger 110. Or it may also completely redirect the flow through the primary heat exchanger 110 or the charging stations 200. The primary loop 108 serves to provide cooling to one or more charging stations 200, referenced in FIG. 1 as 200-1, 200-2, 200-3, ..., 200-n.

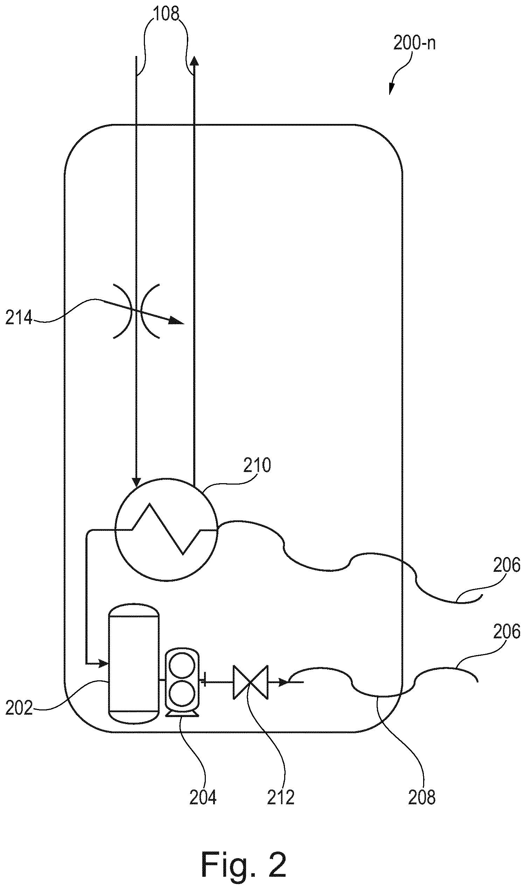

FIG. 2 illustrates an exemplary charging station 200-n. The charging station 200-n comprises a secondary tank 202 for storing coolant, a secondary pump 204, and a secondary conduit, which in this non-limiting example takes the form of (liquid-cooled) cables 206. Although not illustrated in FIG. 2, it is to be noted that such a secondary cooling system may also include coolant loops present in the power modules or power cabinets themselves. The secondary pump 204 is configured to circulate the coolant through a circuit comprising the secondary tank 202 the secondary pump 204, and the cables 206. The secondary tank 202, the secondary pump 204, and the cables 206 taken together thus form a secondary loop 208. The liquid-cooled cables 206 represent one example of the one or more heat-generating components as described herein. In other examples, further heat-generating components (not shown) may form part of the EVCI, as is known in the art, such as EV chargers, power modules, power cabinets, and the like. To avoid profileration of details which are superfluous to the disclosure of the cooling system 100, those components which are actually necessary for charging the EV are not shown in FIG. 2. The charging station 200-n further comprises a secondary heat exchanger 210 configured to exchange heat between the primary loop 108 and the secondary loop 208. In this non-limiting example, the coolant present in both the primary and secondary loops 108, 208 is in liquid form, and the secondary heat exchanger 210 comprises a liquid-liquid heat exchanger. A secondary flow control valve 212 is provided in order to control flow to the cables 206. A further such valve may also be present in the case of liquid-cooled power modules. Yet another flow control valve 214 enables control over how much coolant flows into each charging station 200, including the shutting off of flow to charging stations 200 that are not in use.

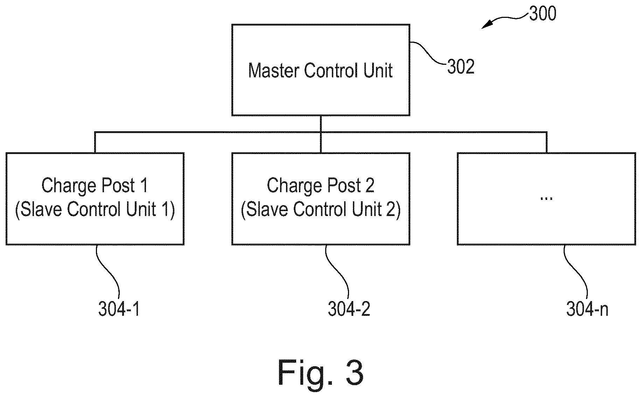

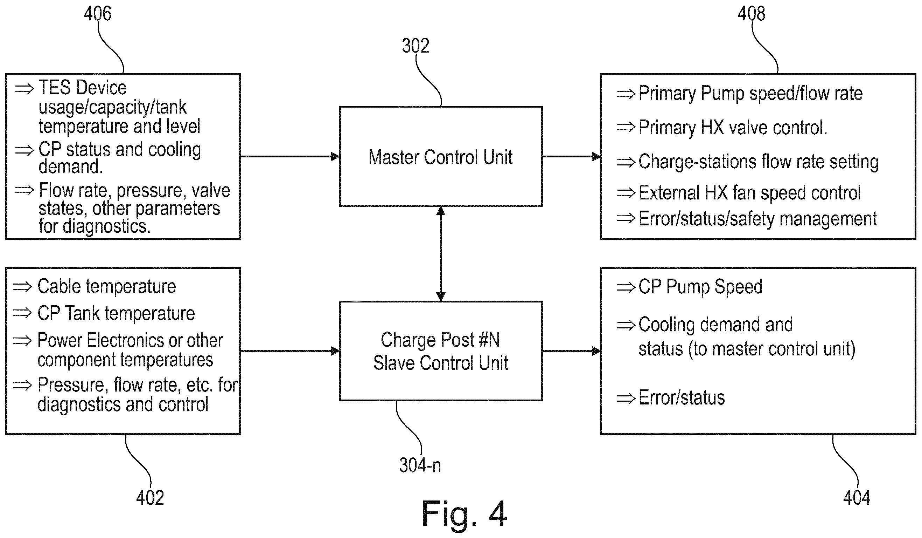

The cooling system 100 further comprises a control system 300, as depicted schematically in FIGS. 3 and 4. The control system 300 comprises a master control unit 302, together with a slave control unit 304 for each individual charging station 200. The slave control units 304 are illustrated in FIG. 3 as 304-1, 304-2, ..., 304-n.

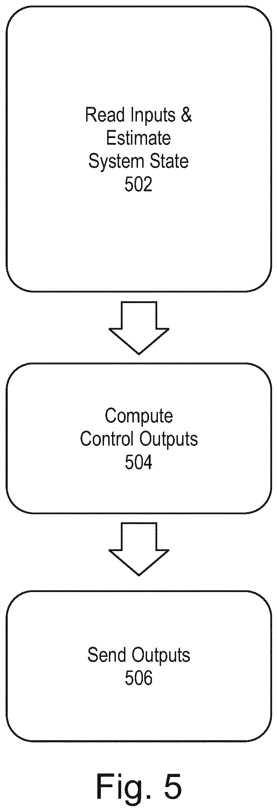

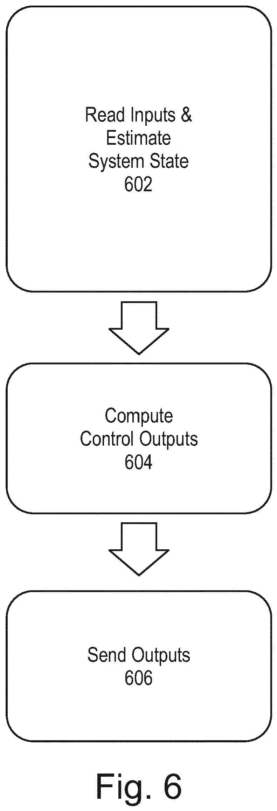

FIGS. 5 and 6 illustrate control algorithms executed by the master control unit 302 and the slave control unit 304-n, respectively.

In use, as depicted in FIG. 4 with reference to FIG. 6, the slave control unit 304-n for a given charging station 200-n receives (in step 602) one or more input signals 402 indicating the system state at the charging station 200-n. In this non-limiting example, the one or more input signals 402 comprise one or more of: a signal indicating temperature in the liquid-cooled cables 206, coolant exit and/or entry temperature at the secondary heat exchanger 212, signals indicating one or more of pressure, flow rate, and pump speed in the secondary loop 208, a signal indicating temperature in the secondary tank 202, one or more signals indicating temperatures of heat-generating components such as power electronics, and optionally also signals indicating values of one or more further parameters used for diagnostic purposes. The slave control unit 304-n may also receive a demand signal from the EV, during communication with the EV, typically indirectly via one or more controllers within the charging station 200-n. The slave control unit 304-n then computes (in step 604) one or more output signals 404 for regulating the equipment in the secondary loop 208 to perform cooling as required by the respective EVCI. The output signals 404 may be computed for example to maintain tank temperature, coolant pressure, coolant return temperature in the secondary loop 208, to ensure that the cables 206 (and optionally also any liquid-cooled power modules) receive adequate cooling, and optionally also to provide for safety and diagnostics in case an error is detected. In this non-limiting example, the output signals 404 comprise one or more of: a pump speed control signal for regulating the speed of the secondary pump 204, a charging station status signal indicating to the master control unit 302 the required cooling (in terms of flow rate, temperature, and/or pressure) for the charge post 200-n, or simply whether cooling is required by the charging station 200-n, and optionally an error signal used for diagnostic purposes. The output signals 404 may further include a control signal for the secondary flow control valve 212. As for the flow control valve 214, this may be controlled by the master control unit 302, as described elsewhere herein, to control the coolant flow distributed to the respective charging station 200-n according to demand. This distribution may be based on a request from the individual charging station 200-n (i.e., from the respective slave control unit 304). The output signals 404 are finally transmitted at step 604.

With reference to FIGS. 4 and 5, the master control unit 302 receives one or more input signals 406 at step 502. In this non-limiting example, the one or more input signals 406 comprise one or more signals indicating conditions in the thermal energy storage element, e.g. the primary tank 102, such as its usage status, capacity, temperature in the primary tank 102, and/or level in the primary tank 102. The input signals 406 may further indicate coolant pressure, temperature, and/or flow rate at one or more other points in the primary loop 108. The input signals 406 may further indicate fan speed, pump speed, and/or valve states for the components of the primary loop 108. The input signals 406 further comprise one or more signals indicating the charging point status received from each slave control unit 304 (which may include the cooling demand, expressed for example in terms of the flow rate demanded by the respective charging station 200), signals indicating the thermal state and/or charging state in one or more of the secondary systems, and optionally also signals indicating values of one or more further parameters used for diagnostic purposes, such as sensor signals to monitor the coolant quality. The master control unit 302 then computes, at step 504, one or more output signals 408 for regulating the equipment in the primary loop 108 to perform cooling as required by the one or more charging points 200. In this non-limiting example, the output signals 408 comprise a pump speed control signal for regulating the speed of the primary pump 104 (and thereby the flow rate in the primary loop 108), valve control signals for regulating opening of one or more of the flow control valves 112, 214 , a fan speed control signal for regulating fan speed in the primary heat exchanger 110, and optionally one or more error signals used for diagnostic purposes.

Numerous variations to the systems and methods described herein may be envisaged. For example, in one variant, a phase-change material may be used. In such a system, the liquid coolant may be passed through a heat transfer element (for example a tubular heat exchanger) inside the thermal energy storage element where the heat is transferred to the phase change material (and vice versa). A similar approach can be used for other forms of thermal energy storage element, in which the primary coolant is different from the material used in the thermal energy storage element.

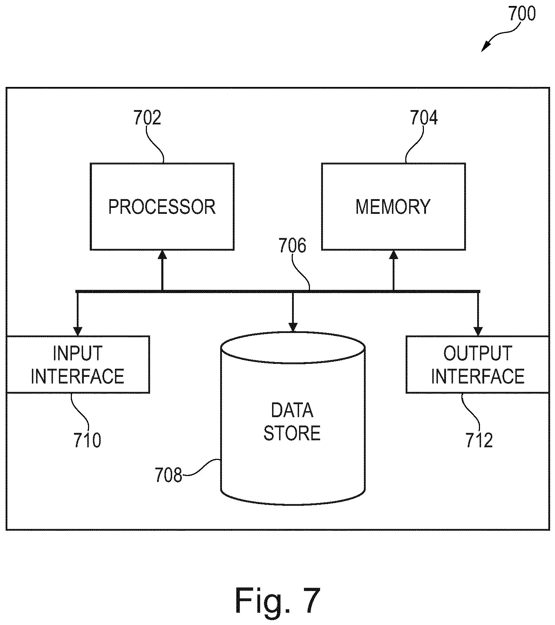

FIG. 7 illustrates an exemplary computing system 700 that can be used in accordance with the systems and methods disclosed herein. The computing system 700 may form part of or comprise any desktop, laptop, server, or cloud-based computing system. The computing system 700 includes at least one processor 702 that executes instructions that are stored in a memory 704. The instructions may be, for instance, instructions for implementing functionality described as being carried out by one or more components described herein or instructions for implementing one or more of the methods described herein. The processor 702 may access the memory 704 by way of a system bus 706. In addition to storing executable instructions, the memory 704 may also store conversational inputs, scores assigned to the conversational inputs, etc.

The computing system 700 additionally includes a data store 708 that is accessible by the processor 702 by way of the system bus 706. The data store 708 may include executable instructions, log data, etc. The computing system 700 also includes an input interface 710 that allows external devices to communicate with the computing system 700. For instance, the input interface 710 may be used to receive instructions from an external computer device, from a user, etc. The computing system 700 also includes an output interface 712 that interfaces the computing system 700 with one or more external devices. For example, the computing system 700 may display text, images, etc. by way of the output interface 712.

It is contemplated that the external devices that communicate with the computing system 700 via the input interface 710 and the output interface 712 can be included in an environment that provides substantially any type of user interface with which a user can interact. Examples of user interface types include graphical user interfaces, natural user interfaces, and so forth. For instance, a graphical user interface may accept input from a user employing input device(s) such as a keyboard, mouse, remote control, or the like and provide output on an output device such as a display. Further, a natural user interface may enable a user to interact with the computing system 700 in a manner free from constraints imposed by input device such as keyboards, mice, remote controls, and the like. Rather, a natural user interface can rely on speech recognition, touch and stylus recognition, gesture recognition both on screen and adjacent to the screen, air gestures, head and eye tracking, voice and speech, vision, touch, gestures, machine intelligence, and so forth.

Additionally, while illustrated as a single system, it is to be understood that the computing system 700 may be a distributed system. Thus, for instance, several devices may be in communication by way of a network connection and may collectively perform tasks described as being performed by the computing system 700.

Various functions described herein can be implemented in hardware, software, or any combination thereof. If implemented in software, the functions can be stored on or transmitted over as one or more instructions or code on a computer-readable medium. Computer-readable media include computer-readable storage media. Computer-readable storage media can be any available storage media that can be accessed by a computer. By way of example, and not limitation, such computer-readable storage media can comprise FLASH storage media, RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Disk and disc, as used herein, include compact disc (CD), laser disc, optical disc, digital versatile disc (DVD), floppy disk, and Blu-ray disc (BD), where disks usually reproduce data magnetically and discs usually reproduce data optically with lasers. Further, a propagated signal may be included within the scope of computer-readable storage media. Computer-readable media also includes communication media including any medium that facilitates transfer of a computer program from one place to another. A connection, for instance, can be a communication medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio and microwave are included in the definition of communication medium. Combinations of the above should also be included within the scope of computer-readable media.

Alternatively, or in addition, the functionally described herein can be performed, at least in part, by one or more hardware logic components. For example, and without limitation, illustrative types of hardware logic components that can be used include Field-programmable Gate Arrays (FPGAs), Program-specific Integrated Circuits (ASICs), Program-specific Standard Products (ASSPs), System-on-a-chip systems (SOCs), Complex Programmable Logic Devices (CPLDs), etc.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features.

It has to be noted that embodiments of the invention are described with reference to different categories. In particular, some examples are described with reference to methods whereas others are described with reference to apparatus. However, a person skilled in the art will gather from the description that, unless otherwise notified, in addition to any combination of features belonging to one category, also any combination between features relating to different category is considered to be disclosed by this application. However, all features can be combined to provide synergetic effects that are more than the simple summation of the features.

While the invention has been illustrated and described in detail in the drawings and foregoing description, such illustration and description are to be considered exemplary and not restrictive. The invention is not limited to the disclosed embodiments. Other variations to the disclosed embodiments can be understood and effected by those skilled in the art, from a study of the drawings, the disclosure, and the appended claims.

The mere fact that certain measures are recited in mutually different dependent claims does not indicate that a combination of these measures cannot be used advantageously.

Any reference signs in the claims should not be construed as limiting the scope.

## Claims

1. A cooling system (100) for an electric vehicle charging infrastructure, the cooling system exhibiting a centralized cooling arrangement in which heat is collected from a plurality of heat-generating components of the electric vehicle charging infrastructure and dissipated into the surrounding environment via a common outlet, the cooling system comprising:
a thermal energy storage element (102) configured to act as a buffer for temporarily storing the heat collected from the plurality of heat-generating components; and
a primary heat exchanger (110), serving as the common outlet, wherein the primary heat exchanger is configured to dissipate the heat temporarily stored by the thermal energy storage element with the surrounding environment.

2. The cooling system of claim 1, further comprising a primary pump (104) and a primary conduit (106), wherein the thermal energy storage element (102), the primary pump (104), and the primary conduit (106) form a primary loop (108) for circulating coolant for the transfer of heat collected from the heat-generating components to the thermal energy storage element.

3. The cooling system of claim 2, further comprising at least one secondary loop (208) for circulating coolant for the transfer of heat from a respective one or more of the heat-generating components to the primary loop (108).

4. The cooling system of claim 3, wherein the secondary loop (208) is positioned at a respective charging station (200), the charging station comprising a secondary coolant container (202), a secondary pump (204), and a secondary conduit (206), wherein the secondary coolant container (202), the secondary pump (204), and the secondary conduit (206) together form the secondary loop (208).

5. The cooling system of claim 4, wherein the charging station (200) further comprises a secondary heat exchanger (210) for exchanging heat collected by the secondary loop (208) from the respective one or more heat-generating components with the primary loop (108).

6. The cooling system of claim 5, wherein the coolant to be circulated in the primary loop (108) comprises a liquid coolant, wherein the coolant to be circulated in the secondary loop (208) comprises a liquid coolant, and wherein the secondary heat exchanger (210) comprises a liquid-liquid heat exchanger.

7. The cooling system of any preceding claim, wherein the primary heat exchanger is positioned remotely from one or more charging stations at which the electric vehicles are to be charged.

8. Electric vehicle charging infrastructure comprising the cooling system (100) of any preceding claim.

9. A method of controlling the cooling system of any of claims 1-7, the method comprising:
controlling the primary heat exchanger (110) to dissipate the heat temporarily stored by the thermal energy storage element with the surrounding environment.

10. The method of claim 9, wherein controlling the primary heat exchanger (110) comprises controlling the primary heat exchanger (110) to operate intermittently while at least one of the heat-generating components is operating.

11. The method of claim 10, wherein controlling the primary heat exchanger (110) to operate intermittently while the at least one heat-generating component is operating comprises controlling the primary heat exchanger to refrain from operating during at least a portion of the time that the at least one heat-generating component is operating.

12. The method of any of claims 9-11, wherein controlling the primary heat exchanger (110) comprises operating the primary heat exchanger while no electric vehicles are being actively charged.

13. A computer-readable medium comprising instructions which, when executed by a computing system, cause the computing system to perform the method of any of claims 9-12.
